# EUROPEAN PATENT APPLICATION

(11) **EP 4 475 145 A1**
(43) Date of publication of application: **11.12.2024**
(21) Application number: 23178508.0
(22) Date of filing: 09.06.2023
(51) Int. Cl.: H01C 7/10, H01C 7/12, H01C 17/00, H01L 23/62, H01L 27/02, H01C 7/102, H01C 7/105, H01C 17/08, H01C 17/28, H10N 60/30, H10N 69/00

(54) **VARISTOR DEVICE AND METHOD OF OPERATING A VARISTOR DEVICE**

(71) Applicant: Terra Quantum AG, 9000 St. Gallen (CH)
(72) Inventor: Vinokour, Valerii, 9000 St. Gallen (CH); Mironov, Alexey, 9000 St. Gallen (CH)
(74) Representative: Kretschmann, Dennis

(57) **Abstract**

A varistor device for voltage-surge-protecting an electronic circuit at a cryogenic temperature comprises an electric lead composed of a superinsulator material, and electrical contact elements. The electrical contact elements are for connecting different positions along the electric lead to the electronic circuit. The electrical contact elements are in electric contact with the electric lead at the different positions along the electric lead. The electric lead is adapted to provide a superinsulating state or a cooper-pair insulating state at the cryogenic temperature, and to provide a non-linear resistance between the different positions at the cryogenic temperature.

## Description

### TECHNICAL FIELD

The disclosure relates to a varistor operable at cryogenic temperatures, such as for superconducting coils or qubits, employing a superinsulator with an essentially vanishing electrical conductivity at the cryogenic temperature.

### BACKGROUND

An important use of a varistor is to protect an electronic device against voltage fluctuations, for example from a power supply or a data input, and against a resulting undesirably high power intake. For this purpose, a varistor is connected in parallel to the device to be protected. The varistor has a nonlinear electrical resistance. Ideally, it would be essentially nonconducting as long as a voltage at the transistor is below a predefined threshold voltage. When the voltage exceeds the threshold voltage, the electrical resistance of the ideal varistor would drastically (i.e., non-linearly) decrease and a current through the varistor would increase accordingly with the voltage. In this idealized situation, the parallel current path provided by the varistor reduces the voltage at the electronic device and the current through it. The nonlinear voltage-dependent resistance of a varistor thus enables it to effectively protect against voltage fluctuations.

Existing varistors, such as those based on a semiconductor (e.g., forming a diode) or on a metal oxide forming internal diodes, are only operable at relatively high temperatures. Varistors according to the state of the art are not suitable for use at cryogenic temperatures, at which devices such as superconducting coils or qubits operate. This is due to the high heating that occurs due to the current through the varistor at voltages greater than the threshold voltage. Another disadvantage of conventional varistors is the poorly controlled value of the on-state electrical resistance. This on-state electrical resistance directly determines the current through the varistor at voltages greater than the threshold voltage and thus the amount to which the varistor is heated. The poor control of the on-state electrical resistance thus results in a poor control over the heating of the varistor.

### OVERVIEW

In view of the technical problems laid out above, there is a need for an improved varistor which is operable at cryogenic temperatures. This problem is solved by a varistor device according to claim 1. Claim 15 provides a method of operating the varistor device.

The varistor device employs a superinsulator material. Superinsulator materials are dual to superconductors, i.e., materials that at low but finite temperatures exhibit a superinsulating state with an essentially infinite resistance so that no electric current can pass through them. A transition from the superinsulating state to a state with a larger resistance may be triggered by a sufficient temperature increase or by applying a sufficiently high voltage. A superinsulating state has been observed in titanium nitride films, niobium titanium nitride films, and in indium oxide films.

According to a first aspect, a varistor device for voltage-surge-protecting an electronic circuit at a cryogenic temperature comprises an electric lead composed of a superinsulator material, and electrical contact elements. The electrical contact elements are for connecting different positions along the electric lead to the electronic circuit. The electrical contact elements are in electric contact with the electric lead at the different positions along the electric lead. The electric lead is adapted to provide a superinsulating state or a cooper-pair insulating state at the cryogenic temperature, and to provide a non-linear resistance between the different positions at the cryogenic temperature.

The varistor device with the superinsulator material provides a strongly nonlinear resistance at the cryogenic temperature, with an absolute value of essentially zero. Thus, the varistor device based on the superinsulator material is ideal for voltage-surge-protecting electronic devices working at cryogenic temperatures. The varistor device itself at the cryogenic temperature shows a low power consumption and a low voltage noise level, with essentially zero leakage current. Those are major advantages of the varistor device over varistors according to the state-of-the-art.

Moreover, the varistor device with the superinsulator material provides voltage current characteristics with a steep increase (in other words, a step or a jump, or a large nonlinearity, respectively) at a threshold voltage. The steepness of the increase, or the magnitude of the nonlinearity, respectively, at the threshold voltage determines to which degree the excessive voltage (and the resulting current, and thus the resulting heating) is taken off the device which is to be protected. The varistor device according to the description takes more of the excessive voltage off the device to be protected than conventional varistors and thus provides an improved voltage-surge- protection.

The electrical resistance of the varistor device may exhibit ohmic behavior, when the voltage applied to the varistor device exceeds the threshold voltage. The resistance in this situation is also referred to as the on-state electrical resistance. This is an advantage over the prior art, wherein the on-state electrical resistance exhibits non-ohmic behavior, but increases more strongly (e.g., exponentially such as in a diode) with the voltage applied to the varistor, resulting in poor control over the on-state electrical resistance. The on-state electrical resistance of the varistor device according to the description can easily be controlled by forming the electric lead with dimensions preselected according to a desired on-state electrical resistance.

The varistor device can be fabricated with a threshold voltage according to a preselection by forming it with dimensions (i.e., in terms of the width and thickness of the electric lead) according to the preselected threshold voltage.

Moreover, the varistor device can be dimensioned (i.e., in terms of the width and thickness of the electric lead) to exhibit a preselected reaction time.

The electrical contact element may comprise or be composed of a superconductor material. The superconductor material may be adapted to provide a superconducting state at the cryogenic temperature.

Corresponding electrical contact elements may provide a minimum resistance at the cryogenic temperature for connecting the electronic circuit, for example to the varistor device and/or to other electrical or electronic components such as a voltage supply.

The electronic circuit may comprise a superconductor component adapted to exhibit superconductivity at the cryogenic temperature, such as a superconductor coil, a superconductor qubit, a SQUID, or a superconductor single-electron transistor.

Corresponding electronic circuits typically operate at cryogenic temperatures. For such devices, a particular need exists for a voltage-surge-protection, which can be cooled to the cryogenic temperature together with the electronic circuit and still be functional/operable. Conventional voltage-surge-protection devices typical operate at much higher temperatures, e.g., at room temperature. The use of such a conventional voltage-surge-protection device requires a connection between it and the electronic circuit to be protected, i.e., a connection between the electronic circuit operating at the cryogenic temperature and a device at higher (e.g., room) temperature. Such a connection is undesirable, for example as it results in thermal transport, and can be avoided with the varistor device according to the description.

The electric lead may be connected to the electronic circuit via the electrical contact elements.

The electric lead may be connected to the electronic circuit electrically in parallel.

The superinsulator material may comprise or be a material from a group containing titanium nitride, niobium titanium nitride, and indium oxide.

The superinsulator material may comprise or be a material from a group containing titanium nitride and niobium titanium nitride.

According to embodiments, a thickness of the electric lead does not exceed 10 nm. In such embodiments, the superinsulator material may comprise or be titanium nitride or niobium titanium nitride or a combination thereof.

The superinsulator material may be titanium nitride, and a thickness of the electric lead may not exceed 5 nm.

The small thickness may help to ensure that the electric lead exhibits a superinsulating state at the cryogenic temperature.

The cryogenic temperature may refer to a temperature of at most 1.5 K or of at most 0.5 K or of at most 0.15 K or of at most 0.05 K.

The electronic circuit and the electric lead may be arranged in thermal contact with a same cooling element. The cooling element may be adapted to provide the cryogenic temperature.

The electric lead may be electrically connected to a reference electrical potential at one of the different positions.

Alternatively, the electric lead may be electrically connected to different reference electrical potentials at the different positions.

A length of the electric lead between the different positions may be at least 1 mm.

Corresponding embodiments of the varistor device may provide a maximum electrical resistance, minimizing energy losses and energy dissipation. A leakage current through the metallic black may be significantly smaller than one 1 pA.

In some embodiments, the length of the electric lead between the different positions may be at least 0.01 mm or at least 0.1 mm.

A length of the electric lead between the different positions may be less than 1 mm.

Corresponding embodiments of the varistor device may minimize its reaction time to a voltage surge and thus provide a high-speed varistor. However, a leakage current through the metallic black of approximately 1 pA may occur.

The superinsulator material may be obtainable using etching, such as plasma etching, a layer of titanium nitride or of niobium titanium nitride.

The superinsulator material of the electric lead may be in physical contact with a dielectric layer.

The dielectric layer may serve to electrically insulate the superinsulator material, e.g., from nearby semiconductor or electrically conducting material.

The superinsulator material of the electric lead may be in physical contact with a growth promoting layer. The growth promoting layer may be adapted to promote a highly crystalline growth of the superinsulator material. In particular, the growth promoting layer may be a dielectric layer, such as the dielectric layer described above.

The dielectric layer may be adapted to provide the growth promoting layer.

The growth promoting layer may comprise or be a nitride, such as aluminum nitride.

In particular, the inventors have experimentally verified that the use of a growth promoting layer of aluminum nitride may increase the critical temperature of the metallic lead and hence the maximum temperature, at which the varistor device may operate, by approximately 10%.

Alternatively, the growth promoting layer or the dielectric layer may comprise or be an oxide, such as silicon dioxide.

The dielectric layer and/or the growth promoting layer may be arranged over a substrate, such as a silicon substrate.

The dielectric layer and/or the growth promoting layer may be arranged between the substrate and the superinsulator material.

According to an embodiment, the superinsulator material is titanium nitride, the substrate is a silicon substrate, and the varistor device comprises a dielectric layer composed of silicon dioxide. In this embodiment, the length of the electric lead may exceed one millimeter.

According to another embodiment, the superinsulator material is titanium nitride, the substrate is a silicon substrate, and the varistor device comprises a growth promoting layer composed of aluminum nitride. In this embodiment, the length of the electric lead may exceed one millimeter.

According to another embodiment, the superinsulator material is composed of niobium titanium nitride, the substrate is a silicon substrate, and the varistor device comprises a dielectric layer composed of silicon dioxide. In this embodiment, the length of the electric lead may exceed one millimeter.

According to another embodiment, the superinsulator material is composed of niobium titanium nitride, the substrate is a silicon substrate, and the varistor device comprises a growth promoting layer composed of aluminum nitride. In this embodiment, the length of the electric lead may exceed one millimeter.

According to another embodiment, the superinsulator material is composed of titanium nitride, and the varistor device comprises a dielectric layer composed of silicon dioxide. In this embodiment, the length of the electric lead may be less than one millimeter.

According to another embodiment, the superinsulator material is composed of titanium nitride, and the varistor device comprises a growth promoting layer composed of aluminum nitride. In this embodiment, the length of the electric lead may be less than one millimeter.

According to another embodiment, the superinsulator material is composed of niobium titanium nitride, and the varistor device comprises a dielectric layer composed of silicon dioxide. In this embodiment, the length of the electric lead may be less than one millimeter.

According to another embodiment, the superinsulator material is composed of niobium titanium nitride, and the varistor device comprises a growth promoting layer composed of aluminum nitride. In this embodiment, the length of the electric lead may be less than one millimeter.

Niobium titanium nitride may refer to material with a chemical composition NbₓTi_{y}N, wherein x is in a range from 0.3 to 0.33, and y is in a range from 0.7 to 0.67.

A second aspect refers to a method of operating a varistor device to voltage-surge-protect an electronic circuit at a cryogenic temperature. The varistor device comprises an electric lead composed of a superinsulator material, and electrical contact elements connecting different positions along the electric lead to the electronic circuit. The electrical contact elements are in electric contact with the electric lead at the different positions along the electrical lead. The method comprises cooling the electric lead to the cryogenic temperature, such that the electric lead is in a superinsulating state or in a cooper-pair insulating state, and provides a non-linear resistance between the different positions at the cryogenic temperature.

A third aspect may refer to a method of forming a varistor device for voltage-surge-protecting an electronic circuit at a cryogenic temperature. The method may comprise forming an electric lead composed of a superinsulator material. The method may further comprise forming electrical contact elements in electric contact with the electric lead at different positions along the electric lead for connecting the different positions along the electric lead to an electronic circuit. The electric lead may be formed to provide a superinsulating state or a cooper-pair insulating state at the cryogenic temperature, and to provide a non-linear resistance between the different positions at the cryogenic temperature.

The method may further comprise providing a dielectric layer and/or a growth promoting layer. The electric lead may be formed over the dielectric layer and/or over the growth promoting layer.

The method may further comprise providing a substrate. The dielectric layer and/or the growth promoting layer may be provided over the substrate.

The electric lead may comprise providing a layer of titanium nitride or niobium titanium nitride, in particular by atomic layer deposition.

Providing the layer of titanium nitride or niobium titanium nitride may comprise depositing titanium nitride or niobium titanium nitride onto the dielectric layer and/or the growth promoting layer, while the dielectric layer and/or the growth promoting layer is kept at a temperature exceeding 300 K or exceeding 310 K or exceeding 320 K or exceeding 330 K or exceeding 340 K. In some embodiments, the temperature does not exceed 400 K, or does not exceed 390 K, or does not exceed 380 K, or does not exceed 370 K, or does not exceed 360 K.

The method may comprise performing an etching process on the layer of titanium nitride or niobium titanium nitride.

The etching process may be performed by plasma etching.

In some embodiments, the etching process is performed for no less than one second, or no less than three seconds.

In some embodiments, the method comprises lithographically patterning the metallic lead to define its width and/or its length.

The forming the electrical contact elements may comprise depositing a superconductor material, for example using a patterned deposition.

### BRIEF DESCRIPTION OF THE FIGURES

The techniques of the present disclosure and the advantages associated therewith will be best apparent from a description of exemplary embodiments in accordance with the accompanying drawings, in which:
- Fig. 1: gives a perspective view of a varistor device according to a first embodiment;
- Fig. 2: gives current-voltage characteristics of a varistor device for three different temperatures of the varistor device;
- Fig. 3a: gives current-voltage characteristics of a varistor device for a magnetic field at the varistor device of zero and of 1 T on a logarithmic-logarithmic scale;
- Fig. 3b: gives the differential conductance corresponding to the measurement of Fig. 3a;
- Fig. 4a: gives current-voltage characteristics of varistor devices of different lengths;
- Fig. 4b: gives the threshold voltages determined from the current-voltage characteristics of Fig. 4a for the varistor devices of the different lengths;
- Fig. 5: gives temporal evolutions of currents through a varistor device when different voltages (as indicated by in mV by the reference numerals) are applied to the varistor device at t ≥ 0, wherein the applied voltage is zero for t < 0;
- Fig. 6: gives a top view of a varistor device according to another embodiment;
- Fig. 7: gives a perspective view of a varistor device according to another embodiment;
- Fig. 8a: illustrates process steps for manufacturing a varistor device;
- Fig. 8b: illustrates another process step for manufacturing the varistor device; and
- Fig. 9: illustrates a method of operating a varistor device.

### DETAILED DESCRIPTION OF EMBODIMENTS

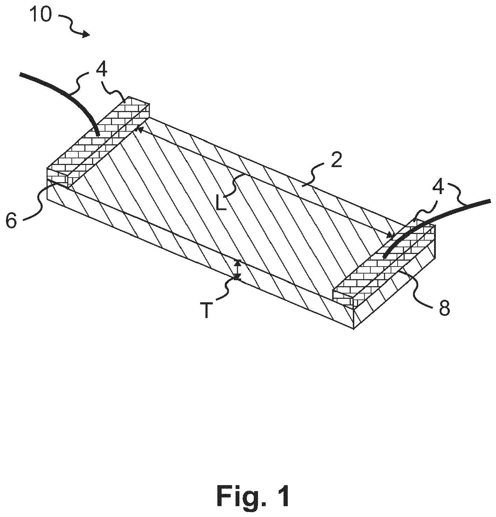

Fig. 1 gives a schematic illustration of a varistor device 10 according to an embodiment.

The varistor device 10 comprises an electric lead 2 composed of a superinsulator material.

Superinsulators are materials dual to superconductors, i.e., materials that at low but finite temperatures provide a superinsulating state. In this superinsulating state, a superinsulator has an essentially infinite resistance so that no electric current can pass through it. The superinsulating state has been observed in titanium nitride films, niobium titanium nitride films, and in indium oxide films.

The electric lead 2 of the varistor device 10 of Fig. 1 is composed of titanium nitride, but another known superinsulator such as niobium titanium nitride or indium oxide or an aluminum layer as described in US 2021/068320 A1 may alternatively be employed.

The varistor device 10 further comprises electrical contact elements 4 in electric contact with the electric lead at different positions 6, 8 along the electric lead.

The electrical contact elements 4 allow for the electric lead 2 to be connected at the different positions 6, 8 to an electronic circuit.

The electrical contact elements 4 are electrically conductive, or metallic, respectively. According to some embodiments, they are composed of superconductor material such as aluminum or niobium.

Using the electrical contact elements 4, the varistor device 10 is typically connected in parallel to an electronic circuit for operation at the cryogenic temperature. This is typically an electronic circuit comprising a superconductor component, such as a superconductor coil, a superconductor qubit, a SQUID, or a superconductor single-electron transistor.

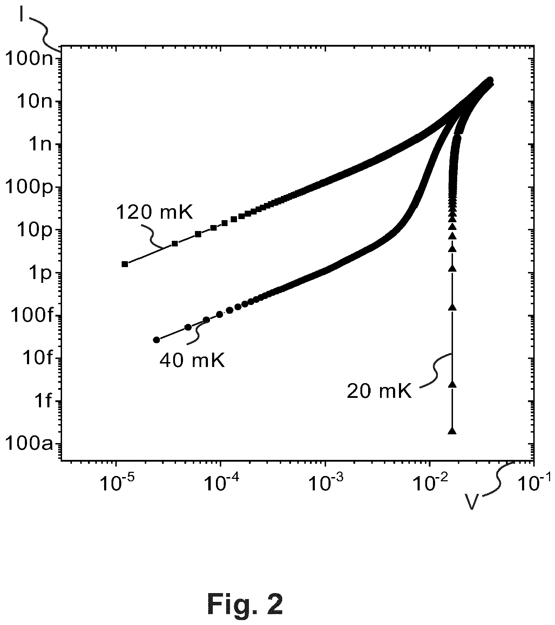

Fig. 2 shows current voltage characteristics of a varistor device 10 similar to the one of Fig. 1. More specifically, the varistor device 10 that the measurements of Fig. 2 have been performed on, comprises an electric lead 2 composed of titanium nitride with a thickness T of 5 nm; a width of 50 µm, and a distance L between the different positions 6, 8 of 2.3 mm. A magnetic field B = 0.2 T has been applied to the electric lead 2 during the measurements of Fig. 2.

Fig. 2 gives the current voltage characteristic between the electrical contact elements 4 for temperature of the metallic lead 2 of 20 mK, 40 mK, and 120 mK. The horizontal axis V indicates the voltage in mV. the vertical axis I indicates the current in A.

In addition to the superinsulating state described above, and to the classical, e.g., ohmic, state at much higher temperatures such as room temperature, most superinsulator materials exhibit a cooper pair insulating state at intermediate temperatures. In other words, when the superinsulator material is heated from a low temperature, at which it exhibits the superinsulating state, it undergoes a first phase transition from this superinsulating state into the cooper pair insulating state at a first critical temperature. When the superinsulator material is heated further, it undergoes a second phase transition from this cooper pair insulating state into the classical, e.g., ohmic, state at a second critical temperature.

At temperatures of the metallic lead 2 below 50 mK and when a voltage smaller than a threshold voltage of the varistor device 10 is applied between the electrical contact elements 4, the superinsulator material is in its superinsulating state. This is observed in Fig. 2 for the temperature of 20 mK and the voltage smaller than ≈ 0.02 mV. In the superinsulating state, the dependence, I(V), of the current I on the applied voltage V, can be described by a power law, *I*∝ *V^{α}*, wherein the power, *α,* increases with decreasing temperature. At the first phase transition out of the superinsulating state, a jump from *α* = 1 to *α* = 3 is observed.

In principle, the nonlinear dependence, I(V), of the current I on the applied voltage V can be applied in the varistor device 10 to provide the nonlinear resistance of the varistor device 10.

When the applied voltage is increased to the threshold voltage of ≈ 0.02 mV, the current I increases drastically. This drastic increase, or jump, or step, or nonlinear increase, respectively, reflects the first phase transition out of the superinsulating state. This drastic increase is preferably used to provide the nonlinear resistance of the varistor device 10. It is particularly suitable for voltage-surge-protecting the electronic circuit at the cryogenic temperature. Such a steep jump is a unique feature of the varistor device according to the description and is unachievable in any prior art varistor. It constitutes a foundation of an unprecedented fast operational time describe below.

At temperatures above 50 mK and below 0.5 K, the superinsulator material exhibits a Cooper pair insulating state different from both the superinsulating state at lower temperature and the classical, e.g., ohmic, state at higher temperature. This is observed in Fig. 2 for the temperature of 120 mK. The dependence, I(V), of the current I on the applied voltage V, is linear within the cooper pair insulating state. However, the current voltage characteristics of the varistor device 10 exhibits a nonlinearity and increases significantly when the applied voltage increases and drives the metallic lead 2 from the Cooper pair insulating state through the second phase transition into the classical, e.g., ohmic, state. This nonlinearity, although less pronounced than the nonlinearity of the first phase transition, can also be used to provide the nonlinear resistance of the varistor device 10. In other words, it can constitute a varistor regime.

At zero magnetic field and for a metallic lead 2 composed of titanium nitride, the phase transition into or out of the superinsulating state (i.e., the first phase transition) occurs at a first critical temperature which is in the range from 10 - 50 mK, depending on the thickness of the metallic lead 2. Films of a smaller thickness show a larger first critical temperature. To ensure the occurrence of the superinsulating state, the thickness T of the metallic lead 2 composed of titanium nitride should be no more than 5 nm. Metallic leads 2 composed of titanium nitride, which exhibit a superinsulating state, exhibit a cooper pair insulating state at temperatures exceeding the first critical temperature. In other words, the first critical temperature corresponds to a phase transition between the superinsulating state and the Cooper pair insulating state. At a higher temperature of up to 0.5 K (second critical temperature), the metallic lead 2 undergoes a second phase transition between the Cooper pair insulating state and a classical state, such as an ohmic state.

A metallic lead 2 composed of niobium titanium nitride undergoes corresponding phase transitions, with a first critical temperature in the range from 0.05 K and 0.15 K and a second critical temperature of up to 1.5 K. To ensure the occurrence of the superinsulating state, the thickness T of the metallic lead 2 composed of niobium titanium nitride should be no more than 10 nm. The occurrence of the superinsulating state has been experimentally verified for niobium titanium nitride with a chemical composition NbₓTi_{y}N, wherein x is in a range from 0.3 to 0.33, and y is in a range from 0.7 to 0.67. However, it is likely that the superinsulating state occurs for a much wider range of x and y.

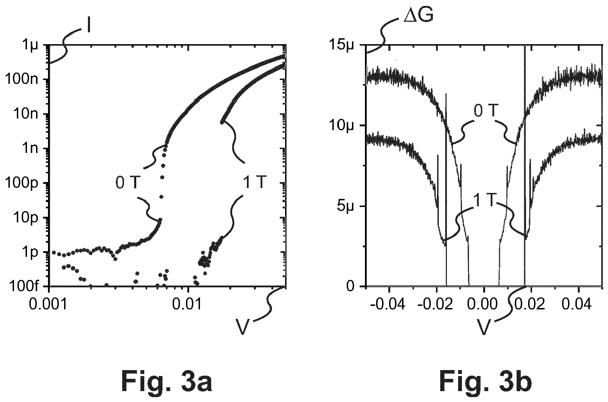

Fig. 3a and Fig. 3b show current voltage characteristics and the differential conductance of a varistor device 10 similar to the one of Fig. 1. More specifically, the varistor device 10 that the measurements of Fig. 3a, Fig. 3b have been performed on, comprises an electric lead 2 composed of niobium titanium nitride with a thickness T of 10 nm, a width of 50 µm, and a distance L between the different positions 6, 8 is 2.3 mm. In Fig. 3a, Fig. 3b, the measured data are given for an applied magnetic field of 0 T and of 1 TC. Experiments were performed with a temperature of the metallic lead 2 of 0.1 K. In Fig. 3a, the horizontal axis V indicates the voltage in V, the vertical axis I indicates the current in A. In Fig. 3b, the horizontal axis V indicates the voltage in V, the vertical axis I indicates the differential conductance in Ω⁻¹.

In Fig. 3a, the drastic increase, or jump, or step, or nonlinear increase, respectively, of the current occurs at a voltage of 0.006 V for B = 0 and at a voltage of 0.2 V for B = 1 T. The corresponding voltages are referred to as threshold voltages.

Correspondingly, the threshold voltage also increases with the applied magnetic field when the metallic lead 2 is composed of titanium nitride (not shown).

The current flowing between the electrical contact elements during the measurements of Fig. 3a, Fig. 3b is about 1 fA in the superinsulating state and about 100 nA in the Cooper pair insulating state. These incredibly low currents are unachievable in prior art varistors, resulting in low leakage and a low noise previously unachievable for varistors.

Fig. 3b presents the differential resistance of the varistor device 10 of Fig. 3a. Its stepwise character at the threshold voltage illustrates the high quality of the varistor device 10.

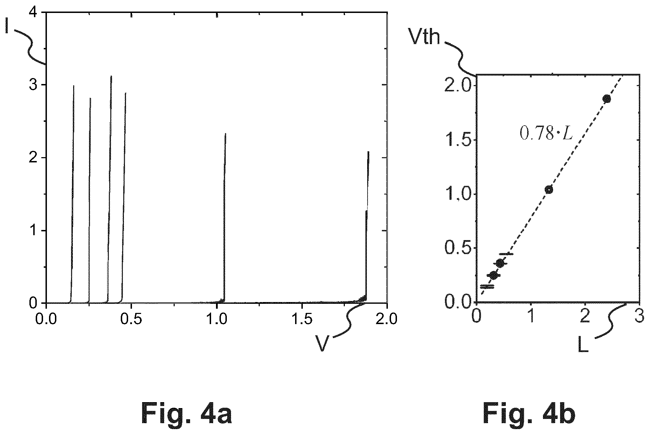

Fig. 4a shows current voltage characteristics of varistor devices 10 similar to the one of Fig. 1. More specifically, the varistor devices 10 that the measurements of Fig. 4a have been performed on, comprise an electric lead 2 composed of niobium titanium nitride with a thickness T of 10 nm, a width of 50 µm, and with different distances L between the different positions 6, 8. No magnetic field has been applied to the electric leads 2 during the measurements of Fig. 4a. The temperature of the metallic lead 2 was 20 mK. The horizontal axis V indicates the voltage in V. the vertical axis I indicates the current in nA.

For all distances L between the different positions 6, 8, the current voltage characteristics exhibit a drastic increase, or jump, or step, or nonlinear increase, respectively, of the current as a function of the applied voltage as similarly described above for the varistor devices 10 according to the previous embodiments. However, the threshold voltage, at which the drastic increase sets in, depends on the distance L between the different positions 6, 8 along the metallic lead 2.

Fig. 4b summarizes the threshold voltages derived from the current voltage characteristics of Fig. 4a. For each current voltage characteristic, the threshold voltage was determined as the voltage V at which the current I exceeds 1 nA. In Fig. 4b, the horizontal axis indicates the distance L between the different positions 6, 8 of the electric lead 2 in mm. The vertical axis Vth indicates the threshold voltage in V.

As Fig. 4a, 4b demonstrate, the threshold voltage can easily be tuned by varying the distance L between the different positions 6, 8 of the electric lead 2.

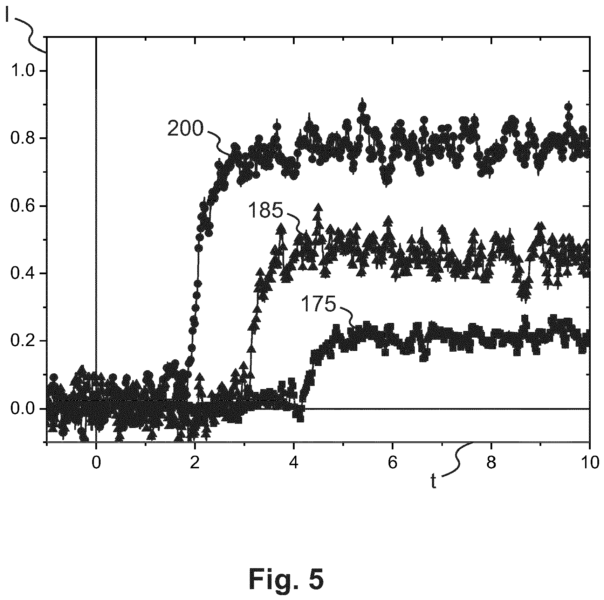

Fig. 5 shows the temporal evolution of the current through a varistor device 10 similar to the one of Fig. 1. More specifically, the varistor device 10 that the measurements of Fig. 5 have been performed on, comprises an electric lead 2 composed of niobium titanium nitride with a thickness T of 9 nm, a width of 50 µm, and a distance between the different positions 6, 8 of 2.3 mm. No magnetic field has been applied to the electric lead 2 during the measurements of Fig. 5. The temperature of the metallic lead 2 was 20 mK. The threshold voltage of this device is 0.058 V. The horizontal axis t indicates the time in µs. The vertical axis I indicates the current in nA. For t < 0 a voltage of zero is applied to electrical contact elements 4. At t ≥ 0, a voltage as indicated (in mV) by the reference numerals (i.e., 175 mV, 185 mV, or 200 mV) is applied to the electrical contact elements 4.

For all applied voltages, the current increases from its initial value at t = 0 to a saturation value at sufficiently large times (e.g., 6 to 10 µs in Fig. 5). The initial value is essentially zero, i.e., it is zero within the accuracy of the measurement.

Details of the temporal evolution, and in particular the saturation value, depend on the difference between the applied voltage and the threshold voltage. A response time may be defined as the time difference between the time t at which the current I reaches 20% of the saturation value, and the time t at which the current I reaches 80% of the saturation value. The response time corresponds to the steepness of the temporal evolution of the current I during its increase. The response time of the varistor device 10 is unprecedently short, i.e., less than 2 µs, unachieved in any prior art device the inventors are aware of.

The response time of around 2 µs occurs as the applied voltage is close to the threshold voltage. With increasing of voltage, the reaction time of the varistor device 10 can be reduced to a few ns. Another way to reach a reaction time of less than 1 µs, less than 0.1 µs, or less than 0.01 µs is to decrease the varistor length, e.g., below 1 mm. However, a side effect of this reduction in length is a blurring of the threshold behavior.

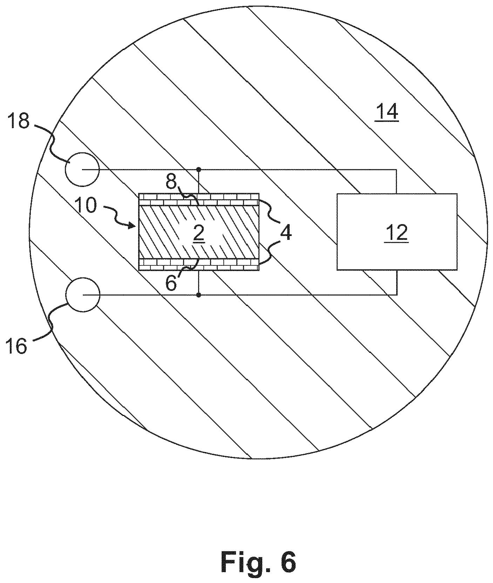

Fig. 6 presents a varistor device 10 according to another embodiment. The varistor device 10 is similar to the one of Fig. 1. Similar components are indicated by same reference numerals and will not be described again for the sake of brevity.

In the embodiment of Fig. 6, the varistor device 10 is arranged on and in thermal contact with a cooling element 14. An electronic circuit 12 that is to be voltage-surge-protected by the varistor device 10 is also arranged on and in thermal contact with the cooling element 14. The varistor device 10 is connected electrically in parallel to the electronic circuit 12 via the electrical contact elements 4. In the embodiment of Fig. 6, the electronic circuit 12 and the varistor device 10 form an integrated circuit, or, in other words, a single chip.

Reference electrical potential 16, 18 are provided to the electronic circuit 12 and the varistor device 10 via electrodes 16, 18 connected to an external power supply.

The electronic circuit 12 comprises at least one superconductor component adapted to exhibit superconductivity at the cryogenic temperature. For example, the electronic circuit 12 can comprise a superconductor coil, a superconductor qubit, a SQUID, or a superconductor single-electron transistor.

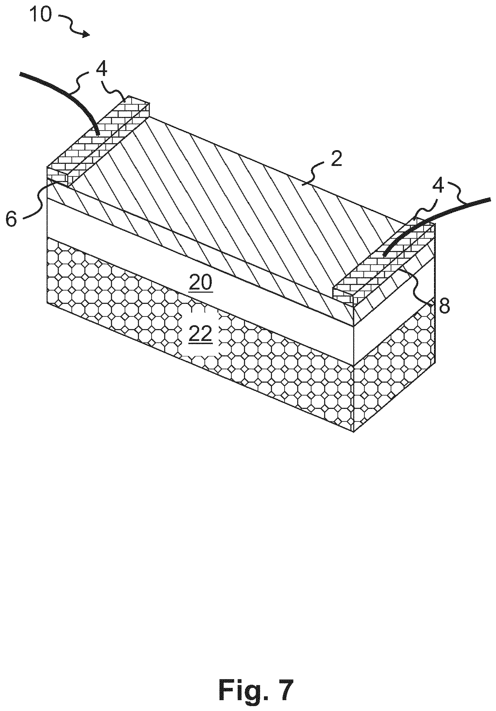

Fig. 7 presents a varistor device 10 according to another embodiment. The varistor device 10 is similar to the one of Fig. 1. Similar components are indicated by same reference numerals and will not be described again for the sake of brevity.

The electric lead 2 of Fig. 7 is formed over a substrate 22. In some embodiments, the substrate 22 is formed as part of the cooling element 14 of Fig. 6.

In the depicted embodiment, the substrate 22 is a silicon wafer.

The substrate 22 serves as a mechanical support for the electric lead 2.

A layer 20 is formed between the electric lead 2 and the substrate 22.

According to some embodiments, the layer 20 serves as an electrical insulator between the electric lead 2 and the substrate 22. In corresponding embodiments, the layer 20 is composed of a dielectric material.

Alternatively, or in addition, the layer 20 serves as a growth promoting layer for the superinsulator material of the electric lead 2. Suitable materials for the growth promoting layer include aluminum nitride and silicon dioxide.

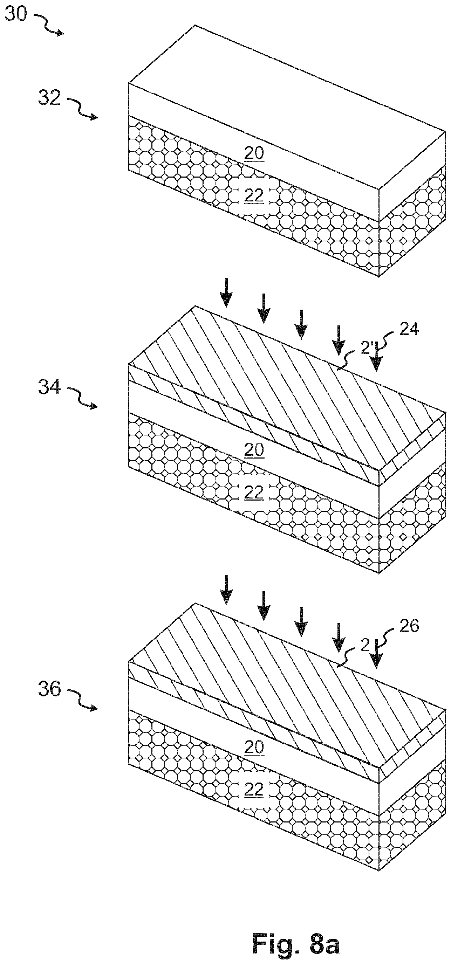

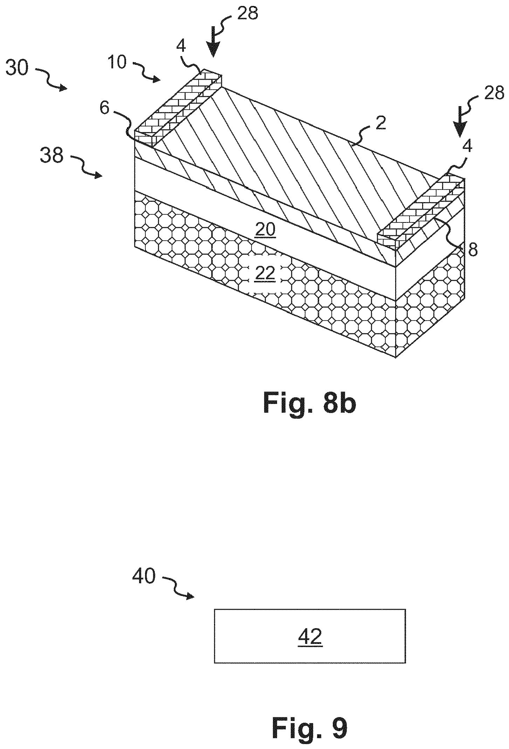

Fig. 8a, Fig. 8b illustrate a method 30 of fabricating a varistor device 10.

At step 32, a layer 20 is provided. In the depicted embodiment, the layer 20 is provided over a substrate 22 providing a mechanical support.

In the depicted embodiment, the layer 20 is composed of aluminum nitride or silicon oxide, more specifically silicon dioxide. The substrate 22 is a silicon substrate 22.

At step 34, a layer 2' of titanium nitride or niobium titanium nitride is provided.

Providing 34 the layer 2' of titanium nitride or niobium titanium nitride is achieved using atomic layer deposition, resulting in step-by-step film growth. This highly controllable process provides superior thickness and stoichiometric uniformity and an atomically smooth surface as compared to chemical vapor deposition, the standard technique used to grow TiN or NbTiN films. However, chemical vapor deposition may in principle also be employed.

For ALD-depositing TiN films, TiCl₄, and NH₃ were used as gaseous reactants. The temperature of the layer 20 during the deposition is 350°C. The titanium nitride film is deposited with a thickness of 5 nm.

For ALD-depositing NbTiN films, NbCl₅, TiCl₄, and NH₃ were used as gaseous reactants. The stoichiometry was tuned by varying the ratio of TiCl_{4/}NbCl₅ in the gas used in the growth cycles. The temperature of the layer 20 during the deposition is 350°C. The niobium titanium nitride film is deposited with a thickness of 10 nm. The chemical composition of the deposited niobium titanium nitride film is NbₓTi_{y}N, wherein x is 0.3 and y is 0.7, wherein x is 0.33, and y is 0.67.

At step 36, an etching process 26 is performed on the layer 2' of titanium nitride or niobium titanium nitride.

The etching process 26 ensures generation of the metallic lead 2 comprising the superinsulator material from the layer 2' of titanium nitride or niobium titanium nitride.

In case of a layer 2' of titanium nitride, the etching process 26 is performed by plasma etching for one second.

In case of a layer 2' of niobium titanium nitride, the etching process 26 is performed by plasma etching for three seconds.

In a subsequent, optional step (not shown), the metallic lead 2 is lithographically patterned to define its width and its length. For example, the metallic lead 2 is lithographically patterned into stripes with widths of 50 µm.

At step 38 of the method 30, depicted in Fig. 8b, electrical contact elements 4 are formed in electric contact with the electric lead 2 at different positions 6, 8 along the electric lead 2 for connecting the different positions 6, 8 along the electric lead 2 to an electronic circuit 12.

In the depicted embodiment, a patterned deposition 28 of aluminum or niobium is performed to deposit electrodes 4 as the electrical contact elements 4. The electrodes 4 were deposited at a distance (equal to the distance between the different positions 6, 8) of 2.5 mm. For experiments in which the current through the electric lead 2 was measured, additional electrodes were deposited between the electrodes 4 for the current measurement. The distance between the additional electrodes was 0.45 mm.

Fig. 9 illustrates a method 40 of operating a varistor device to voltage-surge-protect an electronic circuit at a cryogenic temperature.

Any of the varistor devices 10 described above can be employed as the varistor device of the method 40.

The method 40 comprises at step 42: Cooling 42 the electric lead 2 to the cryogenic temperature, such that the electric lead 2 is in a superinsulating state or in a cooper-pair insulating state, and provides a non-linear resistance between the different positions 6, 8 at the cryogenic temperature.

### LIST OF REFERENCE SIGNS

- 2: electric lead
- 4: electrical contact elements
- 6, 8: different positions along the electric lead
- 10: varistor device
- 12: electronic circuit
- T: Thickness of the electric lead
- L: Length of the electric lead
- 14: cooling element
- 16, 18: reference electrical potentials
- 20: growth promoting layer
- 22: substrate
- 24: depositing superconductor material
- 26: etching/plasma etching the superconductor material
- 28: depositing conductive material
- 30: method for forming a varistor device
- 32: providing a growth promoting layer on a substrate
- 34, 36: forming electric lead
- 38: forming electrical contact elements
- 40: method of operating a varistor device
- 42: cooling the electric lead to the cryogenic temperature

## Claims

1. A varistor device (10) for voltage-surge-protecting an electronic circuit (12) at a cryogenic temperature, the varistor device (10) comprising:
an electric lead (2) composed of a superinsulator material, and
electrical contact elements (4) for connecting different positions (6, 8) along the electric lead (2) to the electronic circuit (12), wherein the electrical contact elements (4) are in electric contact with the electric lead (2) at the different positions (6, 8) along the electric lead (2),
wherein the electric lead (2) is adapted to provide a superinsulating state or a cooper-pair insulating state at the cryogenic temperature, and to provide a non-linear resistance between the different positions (6, 8) at the cryogenic temperature.

2. The varistor device (10) according to claim 1, wherein the electronic circuit (12) comprises a superconductor component adapted to exhibit superconductivity at the cryogenic temperature, such as a superconductor coil, a superconductor qubit, a SQUID, or a superconductor single-electron transistor.

3. The varistor device (10) according to claim 1 or 2, wherein the electric lead (2) is connected to the electronic circuit (12) via the electrical contact elements (4) and/or electrically in parallel.

4. The varistor device (10) according to any of the preceding claims, wherein the superinsulator material comprises or is a material from a group containing titanium nitride, niobium titanium nitride, and indium oxide.

5. The varistor device (10) according to any of the preceding claims, wherein a thickness (T) of the electric lead (2) does not exceed 10 nm.

6. The varistor device (10) according to any of the preceding claims, wherein the superinsulator material is titanium nitride, and a thickness (T) of the electric lead (2) does not exceed 5 nm.

7. The varistor device (10) according to any of the preceding claims, wherein the cryogenic temperature refers to a temperature of at most 1.5 K or of at most 0.5 K or of at most 0.15 K or of at most 0.05 K.

8. The varistor device (10) according to any of the preceding claims, wherein the electronic circuit (12) and the electric lead (2) are arranged in thermal contact with a same cooling element (14), and wherein the cooling element (14) is adapted to provide the cryogenic temperature.

9. The varistor device (10) according to any of the preceding claims,
wherein the electric lead (2) at one of the different positions (6, 8) is electrically connected to a reference electrical potential (16, 18), or
wherein the electric lead (2) at the different positions (6, 8) is electrically connected to different reference electrical potentials (16, 18).

10. The varistor device (10) according to any of the preceding claims, wherein a length (L) of the electric lead between the different positions (6, 8) is at least 1 mm.

11. The varistor device (10) according to any of the preceding claims, wherein the superinsulator material is obtainable using etching (26), such as plasma etching (26), a layer (2') of titanium nitride or niobium titanium nitride.

12. The varistor device (10) according to any of the preceding claims, wherein the superinsulator material of the electric lead (2) is in physical contact with a growth promoting layer (20) adapted to promote a highly crystalline growth of the superinsulator material, in particular a dielectric growth promoting layer (20).

13. The varistor device (10) according to claim 12, wherein the growth promoting layer (20) comprises or is:
a nitride, such as aluminum nitride, or
an oxide, such as silicon dioxide.

14. The varistor device (10) according to claim 12 or 13, wherein the growth promoting layer (20) is arranged over a substrate (22), such as a silicon substrate (22).

15. A method (40) of operating a varistor device (10) to voltage-surge-protect an electronic circuit (12) at a cryogenic temperature, the varistor device (10) comprising:
an electric lead (2) composed of a superinsulator material, and
electrical contact elements (4) connecting different positions (6, 8) along the electric lead (2) to the electronic circuit (12), wherein the electrical contact elements (4) are in electric contact with the electric lead (2) at the different positions (6, 8) along the electrical lead,
wherein the method (40) comprises:
cooling (42) the electric lead (2) to the cryogenic temperature, such that the electric lead (2) is in a superinsulating state or in a cooper-pair insulating state, and provides a nonlinear resistance between the different positions (6, 8) at the cryogenic temperature.

## Amended claims

### Amended claims in accordance with Rule 137(2) EPC.

1. A circuit comprising an electric circuit (12) and a varistor device (10) for voltage-surge-protecting the electronic circuit (12) at a cryogenic temperature, wherein the cryogenic temperature refers to a temperature of at most 1.5 K, the varistor device (10) comprising:
an electric lead (2) composed of a superinsulator material, and
electrical contact elements (4) for connecting different positions (6, 8) along the electric lead (2) to the electronic circuit (12), wherein the electrical contact elements (4) are in electric contact with the electric lead (2) at the different positions (6, 8) along the electric lead (2),
wherein the electric lead (2) is connected to the electronic circuit (12) via the electrical contact elements (4),
wherein the electric lead (2) is adapted to provide a superinsulating state or a cooper-pair insulating state at the cryogenic temperature, and to provide a non-linear resistance between the different positions (6, 8) at the cryogenic temperature, and
wherein the electronic circuit (12) comprises a superconductor component adapted to exhibit superconductivity at the cryogenic temperature.

2. The circuit according to claim 1,
wherein the superconductor component is a superconductor coil, a superconductor qubit, a SQUID, or a superconductor single-electron transistor; and/or
wherein the electrical contact elements (4) comprise or are composed of a superconductor material.

3. The circuit according to claim 1 or 2, wherein the electric lead (2) is connected to the electronic circuit (12) electrically in parallel.

4. The circuit according to any of the preceding claims, wherein the superinsulator material comprises or is a material from a group containing titanium nitride, niobium titanium nitride, and indium oxide.

5. The circuit according to any of the preceding claims, wherein a thickness (T) of the electric lead (2) does not exceed 10 nm.

6. The circuit according to any of the preceding claims, wherein the superinsulator material is titanium nitride, and a thickness (T) of the electric lead (2) does not exceed 5 nm.

7. The circuit according to any of the preceding claims, wherein the cryogenic temperature refers to a temperature of at most 0.5 K or of at most 0.15 K or of at most 0.05 K.

8. The circuit according to any of the preceding claims, wherein the electronic circuit (12) and the electric lead (2) are arranged in thermal contact with a same cooling element (14), and wherein the cooling element (14) is adapted to provide the cryogenic temperature.

9. The circuit according to any of the preceding claims,
wherein the electric lead (2) at one of the different positions (6, 8) is electrically connected to a reference electrical potential (16, 18), or
wherein the electric lead (2) at the different positions (6, 8) is electrically connected to different reference electrical potentials (16, 18).

10. The circuit according to any of the preceding claims, wherein a length (L) of the electric lead between the different positions (6, 8) is at least 1 mm.

11. The circuit according to any of the preceding claims, wherein the superinsulator material is obtainable using etching (26), such as plasma etching (26), a layer (2') of titanium nitride or niobium titanium nitride.

12. The circuit according to any of the preceding claims, wherein the superinsulator material of the electric lead (2) is in physical contact with a growth promoting layer (20) adapted to promote a highly crystalline growth of the superinsulator material, in particular a dielectric growth promoting layer (20).

13. The circuit according to claim 12, wherein the growth promoting layer (20) comprises or is:
a nitride, such as aluminum nitride, or
an oxide, such as silicon dioxide.

14. The circuit according to claim 12 or 13, wherein the growth promoting layer (20) is arranged over a substrate (22), such as a silicon substrate (22).

15. A method (40) of operating a varistor device (10) to voltage-surge-protect an electronic circuit (12) at a cryogenic temperature, wherein the cryogenic temperature refers to a temperature of at most 1.5 K, and wherein the electronic circuit (12) comprises a superconductor component adapted to exhibit superconductivity at the cryogenic temperature, the varistor device (10) comprising:
an electric lead (2) composed of a superinsulator material, and
electrical contact elements (4) connecting different positions (6, 8) along the electric lead (2) to the electronic circuit (12), wherein the electrical contact elements (4) are in electric contact with the electric lead (2) at the different positions (6, 8) along the electrical lead,
wherein the method (40) comprises:
cooling (42) the electric lead (2) to the cryogenic temperature, such that the electric lead (2) is in a superinsulating state or in a cooper-pair insulating state, and provides a non-linear resistance between the different positions (6, 8) at the cryogenic temperature.
